# EUROPEAN PATENT APPLICATION

(11) **EP 4 746 644 A1**
(43) Date of publication of application: **20.05.2026**
(21) Application number: 25171530.6
(22) Date of filing: 21.04.2025
(51) Int. Cl.: H10F 77/70

(54) **SOLAR CELL AND METHOD FOR MANUFACTURING SAME**

(30) Priority: 18.11.2024 CN 202411648896
(71) Applicant: Jinko Solar (Shangrao) Co., Ltd., Shangrao, Jiangxi 334100 (CN); Zhejiang Jinko Solar Co., Ltd., Haining, Zhejiang 314416 (CN)
(72) Inventor: CHEN, Jinjin, Haining, 314416 (CN); YE, Liang, Haining, 314416 (CN); WANG, Hao, Haining, 314416 (CN); CHEN, Qin, Haining, 314416 (CN); GUO, Jiadong, Haining, 314416 (CN); WANG, Zhao, Haining, 314416 (CN); ZHENG, Peiting, Haining, 314416 (CN); YANG, Jie, Haining, 314416 (CN); ZHANG, Xinyu, Haining, 314416 (CN)
(74) Representative: Balder IP Law, S.L.

(57) **Abstract**

Embodiments of the present disclosure relate to the technical field of photovoltaic, and provide a solar cell and a method for manufacturing the same. The solar cell includes a substrate, and the substrate includes a first surface and a second surface opposite to each other. At least one of the first surface or the second surface is formed as a textured surface including a plurality of pyramidal structures, and side walls of at least some of the plurality of pyramidal structures are formed with pleated portions. One respective pleated portion of the pleated portions has a first length and includes at least one scale-like protrusion within the first length, a side wall including the respective pleated portion has a second length, and a ratio of the first length to the second length is greater than or equal to 0.5. The solar cell and the method for manufacturing the same provided in the embodiments of the present disclosure are at least conducive to reducing light reflectance of the solar cell, and to improvement of the photovoltaic conversion efficiency of the solar cell.

## Description

### TECHNICAL FIELD

Embodiments of the present disclosure relate to the field of photovoltaic technologies, and in particular to a solar cell and a method for manufacturing the same.

### BACKGROUND

At present, with gradual depletion of fossil energy, solar cells are being increasingly used as a new energy alternative. A solar cell is a device that converts light energy of the sun into electrical energy. In terms of working principles, the solar cell is based on the photovoltaic effect of a P-N junction in a semiconductor. When light irradiates the P-N junction, electron-hole pairs are generated, carriers generated at the P-N junction in the semiconductor are not recombined to reach a space charge region, and under action of an internal electric field, electrons flow into an N-region and holes flow into a P-region. As a result, excessive electrons accumulate in the N-region, and excessive holes accumulate in the P-region, such that a photogenerated electric field opposite to the direction of a potential barrier is formed in the vicinity of the P-N junction.

In the manufacturing process of solar cells, chemical texturing of substrates by etching is a critical step. This process is intended to reduce surface reflectance of the substrates, enhance light absorption, and increase the density of photogenerated carriers, thereby improving the photovoltaic conversion efficiency of the solar cells. The principle of chemical texturing of the substrates relies on the anisotropy or isotropy of silicon crystals, such that in a chemical solution, etching rates vary on crystal planes or orientations of a substrate. In this way, texturing structures including pyramidal structures of various shapes and sizes can be formed on surfaces of the substrates.

However, the texturing structures will still prevent a considerable amount of light from being utilized, leading to a relatively high light reflectance of the solar cells having such texturing structures. Consequently, the photovoltaic conversion efficiency of the solar cells remains poor.

### SUMMARY

Embodiments of the present disclosure provide a solar cell and a method for manufacturing the same, which are at least conducive to reducing light reflectance of the solar cell, thereby improving the photovoltaic conversion efficiency of the solar cell.

Some embodiments of the present disclosure provide a solar cell. The solar cell includes a substrate, and the substrate includes a first surface and a second surface opposite to each other. At least one of the first surface and the second surface is formed as a textured surface including a plurality of pyramidal structures, and at least some of the plurality of pyramidal structures have side walls with pleated portions. One respective pleated portion of the pleated portions of a respective side wall of the side walls has a first length and includes at least one scale-like protrusion within the first length, the respective side wall has a second length, and a ratio of the first length to the second length is greater than or equal to 0.5.

In some embodiments, the ratio of the first length to the second length is less than or equal to 0.8.

In some embodiments, an included angle formed between two opposite side walls of each pyramidal structure of at least some of plurality of pyramidal structures ranges from 65° to 70°.

In some embodiments, the respective pleated portion includes a plurality of scale-like protrusions connected to each other, and the plurality of scale-like protrusions have a shape of continuous irregular waves. An orthographic projection of scale-like protrusions of a corresponding pyramidal structure of the plurality of pyramidal structures including the respective pleated portion along a direction perpendicular to the first surface or the second surface is in a form of a bud.

In some embodiments, a recess is formed on the side wall including the respective pleated portion, and the respective pleated portion is formed on an inner wall of the recess.

In some embodiments, the solar cell further includes a passivation layer formed on the textured surface and covering surfaces of the plurality of pyramidal structures. The passivation layer includes first portions and second portions corresponding to the pleated portions, surfaces of the first portions away from the plurality of pyramidal structures have shapes same as shapes of surfaces of the pleated portions, and surfaces of the second portions away from the plurality of pyramidal structures have a smooth degree higher than the surfaces of the pleated portions.

Some embodiments of the present disclosure provide a method for manufacturing a solar cell applicable to manufacture the solar cell as described in the above embodiments. The method includes: providing a substrate, where the substrate includes a first surface and a second surface opposite to each other; forming at least one initial textured surface by performing a first texturing process on at least one of the first surface and the second surface of the substrate, where the at least one initial textured surface includes a plurality of initial pyramidal structures; and forming at least one textured surface by performing a second texturing process on the at least one initial textured surface, where the at least one textured surface includes a plurality of pyramidal structures, and at least some of the plurality of pyramidal structures have side walls with pleated portions. One respective pleated portion of the pleated portions of a respective side wall of the side walls has a first length and includes at least one scale-like protrusion within the first length, the respective side wall has a second length, and a ratio of the first length to the second length is greater than or equal to 0.5. A first texturing agent is used in the first texturing process, a second texturing agent is used in the second texturing process, and an alkali concentration in the second texturing agent is less than an alkali concentration in the first texturing agent. A temperature for the second texturing process is lower than a temperature for the first texturing process.

In some embodiments, the alkali concentration in the first texturing agent ranges from 1.8% to 2.2%, and the alkali concentration in the second texturing agent ranges from 0.2% to 0.6%. The temperature for the first texturing process ranges from 80°C to 90°C, and the temperature for the second texturing process ranges from 70°C to 80°C.

In some embodiments, the method further includes: disposing the substrate into a graphite boat; and forming a passivation layer on at least one surface of the substrate using plasma chemical vapor deposition. A number of contact points between the graphite boat and the substrate is greater than or equal to 5.

In some embodiments, one respective initial pyramidal structure of the plurality of initial pyramidal structures has a first surface area, one respective pyramidal structure of the plurality of pyramidal structures has a second surface area, and a ratio of the second surface area to the first surface area ranges from 1.3 to 1.7.

The technical solutions provided in the embodiments of the present disclosure have the beneficial effects as follows.

In the solar cell and the method for manufacturing the solar cell provided in the embodiments of the present disclosure, at least one of the first surface and the second surface of the substrate of the solar cell is formed as a textured surface including a plurality of pyramidal structures. Side walls of at least some of the plurality of pyramidal structures are formed with pleated portions, and one respective pleated portion of the pleated portions includes at least one scale-like protrusion. The pleated portions can increase roughness of side walls of the pyramidal structures, and can increase the probability of multiple reflections of sunlight among the pyramidal structures, thereby trapping the sunlight at the surface(s) of the substrate. In this way, the length of optical path of incident light in the substrate can be increased, and spectral effects of the solar cell can be enhanced, which facilitates more photons to generate electron-hole pairs at a P-N junction region on the surface(s) of the substrate. The generated electron-hole pairs are more easily separated and collected, thereby increasing the collection probability of photogenerated carriers, and improving the photovoltaic conversion efficiency of the solar cell.

### BRIEF DESCRIPTION OF THE DRAWINGS

Exemplary illustrations of one or more embodiments are provided by reference to pictures in the corresponding accompanying drawings. These exemplary illustrations do not constitute a limitation on the embodiments. The drawings do not constitute a scale limitation unless otherwise specified. In order to illustrate the technical solutions in related technologies or in the embodiments of the present disclosure more clearly, the drawings to be used in the embodiments will be briefly described below. It is obvious that the drawings mentioned in the following illustration are only some embodiments of the present disclosure. For those of ordinary skill in the art, other drawings may also be obtained in accordance with these drawings without any inventive effort.
FIG. 1 is a schematic diagram of a cross-section of a substrate of a solar cell in the related art obtained using scanning electron microscope (SEM);
FIG. 2 is a schematic top view of the substrate of the solar cell in the related art obtained using SEM;
FIG. 3 is a schematic diagram of a cross-section of a substrate of a solar cell according to some embodiments of the present disclosure obtained using SEM;
FIG. 4 is a schematic top view of the substrate of the solar cell according to some embodiments of the present disclosure obtained using SEM;
FIG. 5 is a schematic enlarged view of a local structure of a pyramidal structure according to some embodiments of the present disclosure;
FIGS. 6 and 7 are schematic structural diagrams of two pyramidal structures of which surfaces are each covered by a respective passivation layer according to some embodiments of the present disclosure; and
FIG. 8 is a graph showing reflectance of the solar cells according to some embodiments of the present disclosure measured at various wavelengths.

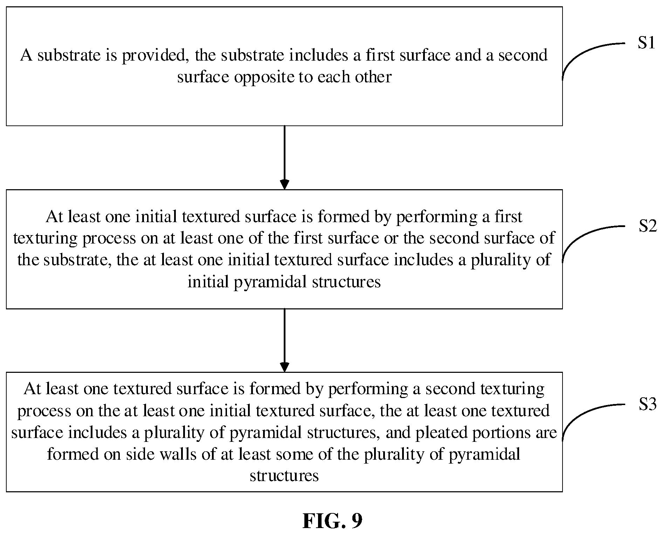

FIG. 9 is a flowchart of a method for manufacturing a solar cell according to some embodiments of the present disclosure.

### DETAILED DESCRIPTION OF THE EMBODIMENTS

As known from the background, the texturing structures will result in a relatively high light reflectance of the solar cells, thereby leading to poor photovoltaic conversion efficiency of the solar cells.

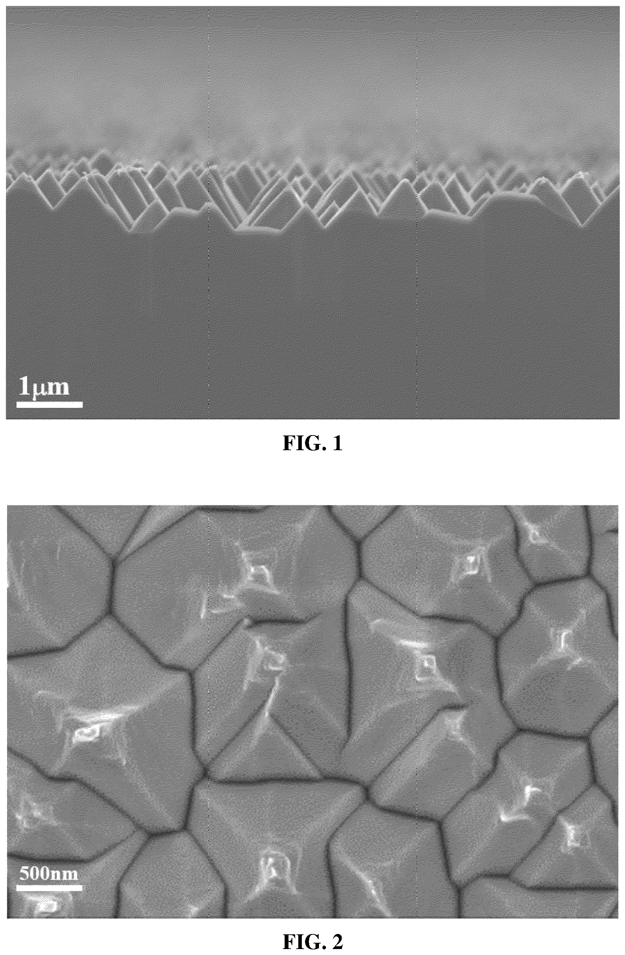

FIG. 1 is a schematic diagram of a cross-section of a substrate of a solar cell in the related art obtained using SEM, and FIG. 2 is a schematic top view of the substrate of the solar cell in the related art obtained using SEM.

In a texturing process, as the first working procedure for manufacturing a solar cell, chemical etching is typically used to form texturing structures on surface(s) of a substrate in conventional mass production, in order to enhance a light-trapping effect of the surface(s) of the solar cell. Due to the fact that etching rates of alkaline texturing agents vary on the crystal planes of the substrate, finally quadrilateral pyramidal structures (also known as pyramidal structures, as illustrated in FIG. 1 and FIG. 2) each having four respective (111) crystal planes are formed. Currently, an alkaline texturing process can control a nucleation process of the pyramidal structures, which effectively reduces the surface tension at a solid-liquid interface and suppresses further expansion of bubbles during reaction, thereby controlling the reaction rate and allowing the hydrogen gas generated during reaction to quickly escape from the surface(s) of the substrate. In this way, uniformity of the textured surface can be ensured. Typically, a ratio of a height of a pyramidal structure to a length of a bottom edge of the pyramidal structure is 0.5:1, or an included angle formed between an inclined surface of the pyramidal structure and a bottom of the pyramidal structure ranges from 52° to 53°. The pyramidal structures having bottoms with relatively large dimensions cause that a large amount of light is reflected to the outside of the substrate by side surfaces of the pyramidal structures. As a result, the texturing structures of the substrate will still prevent a considerable amount of light from being utilized, leading to a relatively high light reflectance of the solar cells having such texturing structures. Consequently, the photovoltaic conversion efficiency of the solar cells is poor.

The conventional texturing structures formed as pyramidal structures has a relatively high reflectance (10% to 10.5%), and fails to efficiently trap light, which becomes a factor hindering improvement of the photovoltaic conversion efficiency of the solar cell. In order to increase the light absorption efficiency of the solar cell, nano-texturing structures, such as black silicon technology (inverted pyramid), have been used, which can reduce the reflectance to as low as 1.5% or even lower. However, the nano-textured surfaces are disordered, have poor passivation, and suffer severely reduced efficiency. Additionally, the process is more complex. Furthermore, the nano-texturing structures contain metallic components, which increase costs and lead to contamination of tank and post-processing stages, and therefore are not fully compatible with mass production devices.

The embodiments of the present disclosure provide a solar cell and a method for manufacturing solar cells, at least one of the first surface and the second surface of the substrate of the solar cell is formed as a textured surface including a plurality of pyramidal structures. Side walls of at least some of the plurality of pyramidal structures are formed with pleated portions, and one respective pleated portion of the pleated portions includes at least one scale-like protrusion. The pleated portions can increase roughness of side walls of the pyramidal structures, and can increase the probability of multiple reflections of sunlight among the pyramidal structures, thereby trapping the sunlight at the surface(s) of the substrate. In this way, the length of optical path of incident light in the substrate can be increased, and spectral effects of the solar cell can be enhanced, which facilitates more photons to generate electron-hole pairs at a P-N junction region on the surface(s) of the substrate. The generated electron-hole pairs are more easily separated and collected, thereby increasing the collection probability of photogenerated carriers, and improving the photovoltaic conversion efficiency of the solar cell.

In the description of the embodiments of the present disclosure, the technical terms "first", "second", and the like are merely intended to distinguish different objects, and shall not be understood as an indication or implication of relative importance or implicit indication of the number, specific sequence, or dominant-subordinate relationship of the technical features indicated.

In the description of the embodiments of the present disclosure, "a plurality of" means two or more, unless otherwise specifically stated.

The term "embodiment" described herein means that specific features, structures, or characteristics described in combination with the embodiments may be incorporated in at least one embodiment of the present disclosure. Phrases appearing at various positions of the specification refer to neither the same embodiment nor separate or alternative embodiments that are mutually exclusive with other embodiments. It is explicitly and implicitly understood by those skilled in the art that the embodiments described herein may be combined with other embodiments.

In the description of the embodiments of the present disclosure, the term "and/or" herein is merely an association relationship describing associated objects, indicating that three relationships may exist. For example, A and/or B indicates that there are three cases of A alone, A and B together, and B alone. In addition, the character "/" herein generally indicates an "or" relationship between the associated objects.

In the description of the embodiments of the present disclosure, the orientation or position relationships indicated by the technical terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present disclosure and simplify the description only, rather than indicating or implying that the apparatus or element referred to must have a particular orientation or be constructed and operated in a particular orientation, and therefore are not to be interpreted as limiting the embodiments of the present disclosure.

In the drawings corresponding to the embodiments of the present disclosure, for better understanding and ease of description, a thickness and an area of a layer are exaggerated. When a component is described as being on the other component or on a surface of the other component, the component may be "directly" on the surface of the other component or there may be a third component between the two components. In contrast, when one component is described as being at the surface of the other component or the other component is formed at or provided at a surface of one component, there is no third component between the two components. In addition, when a component is described as being "substantially" formed on the other component, it means that the component is neither formed on the entire surface (or a front surface) of the other component, nor formed on part of an edge of the entire surface.

In the description of the embodiments of the present disclosure, when a component "includes" another component, other components are not excluded and may further be included unless otherwise stated.

The terms used in the description of the embodiments herein are for describing particular embodiments only and not intended to be limiting. As used in the description of the embodiments described and in the appended claims, "component" is also intended to include the plural form unless the context clearly indicates otherwise.

Various embodiments of the present disclosure will be described in detail below with reference to the accompanying drawings. However, those of ordinary skill in the art shall understand that in the embodiments of the present disclosure, many technical details are provided to enable readers to better understand the embodiments of the present disclosure. However, even without these technical details and various changes and modifications based on the following embodiments, the technical solutions claimed in the embodiments of the present disclosure can still be implemented.

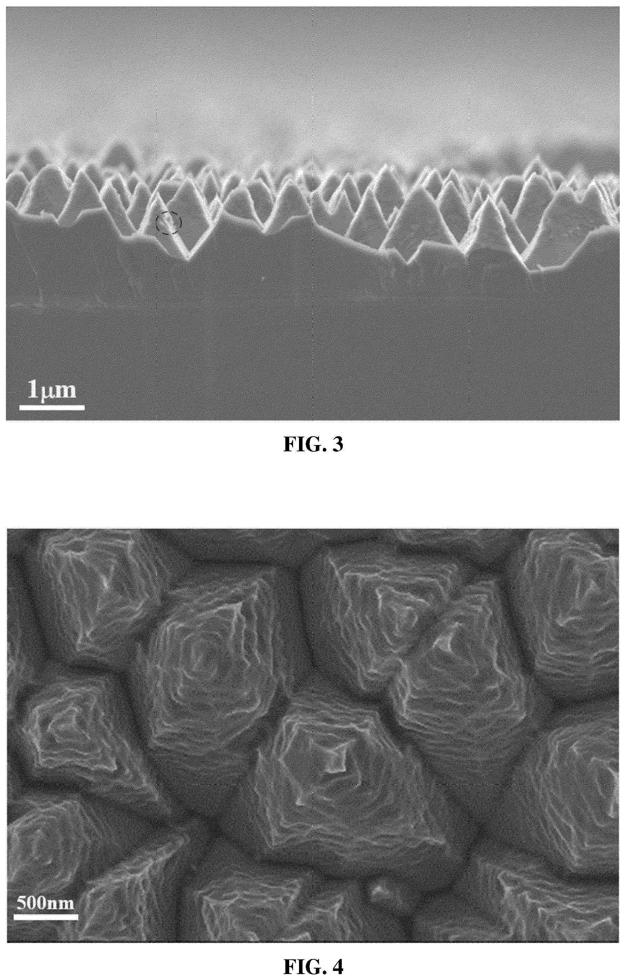

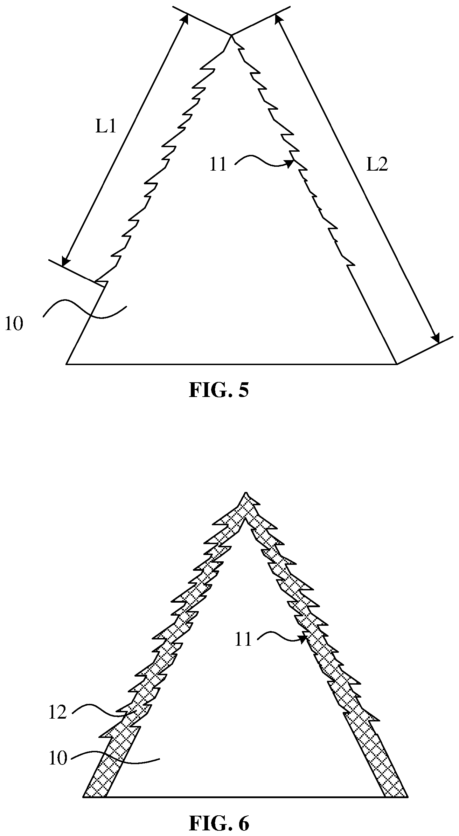

FIG. 3 is a schematic diagram of a cross-section of a substrate of a solar cell according to some embodiments of the present disclosure obtained using SEM; FIG. 4 is a schematic top view of the substrate of the solar cell according to some embodiments of the present disclosure obtained using SEM; and FIG. 5 is a schematic enlarged view of a local structure of a pyramidal structure according to some embodiments of the present disclosure.

The solar cell according to some embodiments of the present disclosure includes a substrate including a first surface and a second surface opposite to each other, and at least one of the first surface and the second surface is a textured surface. Referring to FIGS. 3 and 4, the textured surface includes a plurality of pyramidal structures. Side walls of at least some of the plurality of pyramidal structures are formed with pleated portions. One respective pleated portion of the pleated portions includes at least one scale-like protrusion. Referring to FIG. 5, one respective pleated portion of the pleated portions 11 has a first length L1, a sidewall including the respective pleated portion has a second length L2, and a ratio of the first length L1 to the second length L2 is greater than or equal to 0.5, for example, the ratio may be 0.5, 0.56, 0.6, 0.64, 0.7, 0.75, 0.8, 0.96, or 1. The first length L1 is measured along a perpendicular line from a vertex of one respective pyramidal structure of the plurality of pyramidal structures to a bottom edge of the respective pyramid structure. In a direction directing from the vertex to the bottom edge of the respective pyramidal structure, a starting position for measuring the first length L1 is set to a first scale-like protrusion of the one respective pleated portion, and an ending position for measuring the first length L1 is set to the last scale-like protrusion of the one respective pleated portion.

In the solar cell according to the embodiments of the present disclosure, at least one of the first surface and the second surface of the substrate of the solar cell is formed as a textured surface including a plurality of pyramidal structures. Side walls of at least some of the plurality of pyramidal structures are formed with pleated portions, and one respective pleated portion of the pleated portions includes at least one scale-like protrusion. The pleated portions can increase roughness of side walls of the pyramidal structures, and can increase the probability of multiple reflections of sunlight among the pyramidal structures, thereby trapping the sunlight at the surface(s) of the substrate. In this way, the length of optical path of incident light in the substrate can be increased, and spectral effects of the solar cell can be enhanced, which facilitates more photons to generate electron-hole pairs at a P-N junction region on the surface(s) of the substrate. The generated electron-hole pairs are more easily separated and collected, thereby increasing the collection probability of photogenerated carriers, and improving the photovoltaic conversion efficiency of the solar cell.

It should be noted that, referring to FIG. 3, the degree of pleating varies at different positions on side walls of a pyramidal structure. Therefore, the pyramidal structure has an appearance that the scale-like protrusions corresponding to the pleated portions at the top of the pyramidal structure are less pronounced compared to those corresponding to the pleated portions in the middle of the pyramidal structure.

In some embodiments, the solar cell may be any one of: a passivated emitter and rear cell (PERC), a passivated emitter and rear totally-diffused (PERT) cell, a tunnel oxide passivated contact (TOPCon) cell, a heterojunction technology (HIT/HJT) cell, or a back contact (BC) cell.

In some embodiments, the solar cell may be a monocrystalline silicon solar cell, a polycrystalline silicon solar cell, an amorphous silicon solar cell, or a multicomponent compound solar cell. The multicomponent compound solar cell may be a cadmium sulfide (CdS) solar cell, a gallium arsenide (GaAs) solar cell, a copper indium selenide (CIS) solar cell, or a perovskite solar cell.

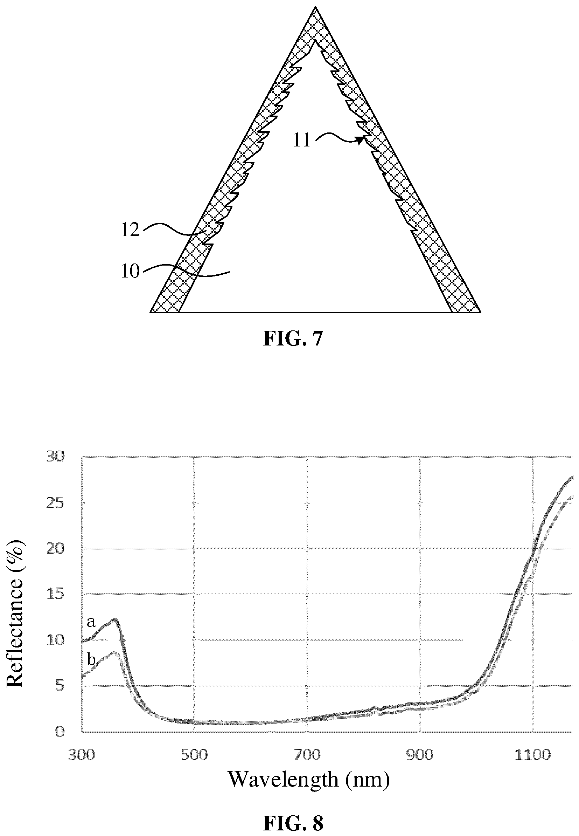

FIG. 6 and FIG. 7 are schematic structural diagrams of two pyramidal structures of which surfaces are each covered by a respective passivation layer according to some embodiments of the present disclosure.

Referring to FIG. 6 and FIG. 7, in some embodiments, the solar cell further includes a passivation layer 12 formed on the textured surface and covering surfaces of the plurality of pyramidal structures 10. The passivation layer 12 includes first portions and second portions corresponding to the pleated portions, referring to FIG. 6, surfaces of the first portions away from the plurality of pyramidal structures 10 have shapes same as shapes of surfaces of the pleated portions 11; or referring to FIG. 7, surfaces of the second portions away from the plurality of pyramidal structures 10 have a smooth degree higher than the surfaces of the pleated portions 11. On the textured surface of the substrate, the pleated portions 11 on the side walls of the pyramidal structures 10 in various regions have different roughness. When the undulation of the pleated portions 11 relative to the side walls of the pyramidal structures 10 is relatively large or pronounced, and the passivation layer 12 is uniformly deposited across the surfaces of the pyramidal structures 10, the surface of the passivation layer 12 away from the plurality of pyramidal structures 10 has shapes same as shapes of surfaces of the pleated portions 11 (as illustrated in FIG. 6). Conversely, when the undulation of the pleated portions 11 relative to the side walls of the pyramidal structures 10 is relatively small or not pronounced, and the passivation layer 12 is uniformly deposited across the surfaces of the pyramidal structures 10, the coverage of the passivation layer 12 reduces the undulation effect of the pleated portions 11 relative to the side walls of the pyramidal structures 10. Therefore, the surface of the passivation layer 12 away from the pyramidal structures 10 has a smooth degree higher than the surfaces of the pleated portions 11 (as illustrated in FIG. 7).

In some embodiments, the passivation layer includes a first passivation layer and a second passivation layer. The first passivation layer is disposed on the first surface, and the second passivation layer is disposed on the second surface. The first and second passivation layers can prevent oxidation or corrosion of the surfaces of the substrate, thereby improving the stability and lifespan of the solar cell.

The first passivation layer may be made of at least one of aluminum oxide, silicon oxide, silicon nitride, or silicon oxynitride. The first passivation layer may have either a single-layer structure or a multilayer structure. For example, the single-layer structure may be a single-layer aluminum oxide film, a single-layer silicon oxide film, a single-layer silicon nitride film, or a single-layer silicon oxynitride film. The multilayer structure may include a stack of at least two layers selected from an aluminum oxide film, silicon oxide film, a silicon nitride film, and a silicon oxynitride film.

The second passivation layer may be made of at least one of aluminum oxide, silicon oxide, silicon nitride, or silicon oxynitride. The second passivation layer may have either a single-layer structure or a multilayer structure. For example, the single-layer structure may be a single-layer aluminum oxide film, a single-layer silicon oxide film, a single-layer silicon nitride film, or a single-layer silicon oxynitride film. The multilayer structure may include a stack of at least two layers selected from an aluminum oxide film, silicon oxide film, a silicon nitride film, and a silicon oxynitride film.

In some embodiments, the substrate may include an emitter. The emitter may be formed on a side of the substrate facing the first passivation layer and may be in contact with the first passivation layer. Alternatively, the emitter may be formed on a side of the substrate facing the second passivation layer and may be in contact with the second passivation layer. The doping type of the emitter is opposite to that of the substrate. For example, when the substrate is doped with a p-type dopant, the emitter is doped with an n-type dopant; and conversely, when the substrate is doped with an n-type dopant, the emitter is doped with a p-type dopant. In this way, a P-N junction is formed between the emitter and the substrate. The P-N junction may receive and absorb incident light that is irradiated onto the surface of the substrate and generate electron-hole pairs. For example, when the substrate is an n-type substrate, separated electrons move into the substrate, and separated holes move into the emitter, such that an electric current is generated.

The substrate may be an N-type semiconductor substrate or a P-type semiconductor substrate. The N-type semiconductor substrate is doped with an N-type doping element. The N-type doping element may be any one of group-V elements, such as potassium (P), bismuth (Bi), antimony (Sb), arsenic (As), or the like. The P-type semiconductor substrate is doped with a P-type doping element. The P-type doping element may be any one of group-III elements, such as boron (B), aluminum (Al), gallium (Ga), indium (In), or the like.

The substrate may be made of at least one of monocrystalline silicon, polycrystalline silicon, amorphous silicon, or microcrystalline silicon.

When the solar cell is a monofacial solar cell, a textured surface may be formed on one side of the substrate 100, and the other surface of the substrate may be a polished surface, that is, the polished surface of the substrate is flatter and smoother compared to the textured surface. It should be noted that with respect to the monofacial solar cell, textured surfaces may be formed on both sides of the substrate. When the solar cell is a bifacial solar cell, textured surfaces may be formed on both sides of the substrate.

In some embodiments, the solar cell may further include a tunneling layer and a doped conductive layer. The tunneling layer is disposed on a surface of the substrate away from the emitter, and the doped conductive layer is disposed on a surface of the tunneling layer away from the substrate. The tunneling layer and the doped conductive layer are configured to form a passivated contact structure. The tunneling layer may achieve a chemical passivation effect. Due to the presence of interface state defects on the surface of the substrate, the tunneling layer can saturate dangling bonds at the surface of the substrate, reduce a defect state density at the surface of the substrate, and decrease recombination centers at the surface of the substrate to lower a carrier recombination rate, such that the interface state density at the surface of the substrate is increased. The increase in the interface state density promotes the recombination of photogenerated carriers, and thus increases a fill factor, a short-circuit current, and an open-circuit voltage of the solar cell, such that the photoelectric conversion efficiency of the solar cell can be improved. The doped conductive layer can achieve a field passivation effect. The doped conductive layer can generate an electrostatic field that causes minority carriers to escape from the interface, thereby reducing concentration of the minority carriers. In this way, the recombination rate of carriers at the interface of the substrate can be reduced, such that the open-circuit voltage, the short-circuit current, and the fill factor of the solar cell can be increased, thereby improving the photoelectric conversion efficiency of the solar cell.

The tunneling layer may be made of at least one of silicon oxide, silicon nitride, silicon oxynitride, silicon carbide, or magnesium fluoride.

The doped conductive layer may be made of at least one of amorphous silicon, polycrystalline silicon, or silicon carbide. The doped conductive layer includes a doping element of the same type as that in the substrate. When the type of the doping element in the substrate is P-type, the type of the doping element in the doped conductive layer is also P-type. When the type of the doping element in the substrate is N-type, then the type of the doping element in the doped conductive layer is also N-type.

Referring to FIG. 5, in some embodiments, the ratio of the first length L1 to the second length L2 is less than or equal to 0.8.

Table 1 lists the reflectance corresponding to various solar cells provided in the embodiments of the present disclosure.

**Table 1 Reflectance of Various Solar Cells**

| Examples | With pleated portions or not? | Ratio of first length to second length (L1/L2) | Angle of apex | Reflectance |
|---|---|---|---|---|
| Comparative Example 1 | No | / | 70° to 75° | 10% to 10.5% |
| Comparative Example 2 | No | / | 65° to 70° | 7% to 8% |
| Example 1 | Yes | 1/5 | | 6.8% to 7% |
| Example 2 | Yes | 1/3 | | 6% to 7% |
| Example 3 | Yes | 2/3 | | 3% to 5% |
| Example 4 | Yes | 1 | | 3% to 5% |

As listed in Table 1, the substrates of the solar cells corresponding to Comparative Example 1 and Comparative Example 2 have conventional textured surfaces, where the side walls of the pyramidal structures on the textured surfaces are smooth and no pleated portions are formed on the side walls. In contrast, the solar cells corresponding to Examples 1 to 4 have pleated portions on the surfaces of the substrates, and the ratio of the first length L1 of one respective pleated portion to the length L2 of a side wall of a corresponding pyramidal structure progressively increases.

Referring to Table 1, a comparison between Comparative Example 2 and Examples 1 to 4 reveals that when pleated portions are formed on the surfaces of the substrates of the solar cells, as compared to the conventional textured surface, the reflectance of the solar cells is reduced. A comparison of Examples 1 to 4 reveals that when the ratio of the first length L1 to the second length L2 is relatively small, the reduction in the reflectance of the solar cells is slight. As the ratio of the first length L1 to the second length L2 increases, the areas occupied by the pleated portions on the side walls of the pyramidal structures increase, such that a more significant reduction in the reflectance of the solar cells is achieved. However, when the ratio of the first length L1 to the second length L2 continues to increase until the entire side walls of the pyramidal structures are occupied, the additional reduction in reflectance of the solar cells becomes less pronounced. Therefore, when the ratio of the first length L1 to the second length L2 is greater than 0.5 and less than or equal to 0.8, the reflectance of the solar cells can be maintained at a relatively low level. In addition, when the ratio of the first length L1 to the second length L2 is too large, the processing time required to form the pleated portions increases, leading to a deterioration in the uniformity of the pleated portions, which cannot significantly reduce the reflectance of the solar cells, but lowers the manufacturing efficiency of the solar cells. Therefore, the ratio of the first length L1 to the second length L2 that is within an appropriate range is conducive to providing a relatively high uniformity and relatively low reflectance of the textured surfaces, and to the improvement of the manufacturing efficiency of the solar cells.

Referring to Table 1, a comparison between Comparative Example 1 and Comparative Example 2 reveals that for conventional textured surfaces, the reflectance of the solar cells is lower when an apex angle of the pyramidal structures (i.e., the included angle formed between two side walls of a pyramidal structure opposite to each other) ranges from 65° to 70°, compared to a case where the apex angle of the pyramidal structures ranges from 70° to 75°. This is because a sharper apex angle of the pyramidal structures favors multiple reflections of sunlight among adjacent pyramidal structures, such that the sunlight is more prone to be trapped at the surfaces of the substrate, thereby achieving a better light-trapping effect and improving the photovoltaic conversion efficiency of the solar cell.

FIG. 8 is a graph showing reflectance of the solar cells according to some embodiments of the present disclosure measured at various wavelengths. The curve labeled "a" in FIG. 8 corresponds to the data for Comparative Example 1 in Table 1, and the curve labeled "b" in FIG. 8 corresponds to the data for Example 3 in Table 1.

Referring to Table 1 and FIG. 8, it can be seen that, compared to conventional textured surfaces, in the solar cell according to the embodiments, which features pleated portions on the side walls of the pyramidal structures, the included angle formed between the two side walls of a pyramidal structure opposite to each other is maintained, namely an apex angle ranges from 65° to 70°. In this way, the light-trapping effect at the surfaces of the substrate can be further improved. As a result, the reflectance of the solar cells can be reduced at various wavelengths, thereby improving the photovoltaic conversion efficiency of the solar cells.

Referring to FIG. 4, in some embodiments, one respective pleated portion includes a plurality of scale-like protrusions connected to each other, and the plurality of scale-like protrusions have a shape of continuous irregular waves. An orthographic projection of scale-like protrusions of a corresponding pyramidal structure of the plurality of pyramidal structures including the respective pleated portion along a direction perpendicular to the first surface or the second surface is in a form of bud. The irregular bud-like structure facilitates irregular reflections of incident light among adjacent pyramidal structures, which is conducive to elongating the optical path of the incident light in the substrate, and enhancing spectral effects of the solar cell. Thus, more photons are promoted to generate electron-hole pairs at a P-N junction region on the surface(s) of the substrate, thereby increasing the collection probability of photogenerated carriers, and improving the photovoltaic conversion efficiency of the solar cell.

Referring to FIG. 3, in some embodiments, a recess (such as the one denoted by the dashed circle in FIG. 3) is formed on the side wall of a pyramidal structure including one respective pleated portion due to etching, and the respective pleated portion is formed on an inner wall of the recess. The recesses can increase the surface area of the side walls of the pyramidal structure. The pleated portions, which are also present within the recesses, can increase the roughness of the inner walls of the recesses. In this way, the light-trapping effect of the textured surfaces and therefore the photovoltaic conversion efficiency of the solar cell can be improved.

In the solar cell provided in the embodiments of the present disclosure, at least one of the first surface and the second surface of the substrate of the solar cell is formed as a textured surface including a plurality of pyramidal structures. Side walls of at least some of the plurality of pyramidal structures are formed with pleated portions, and one respective pleated portion of the pleated portions includes at least one scale-like protrusion. The pleated portions can increase roughness of side walls of the pyramidal structures, and can increase the probability of multiple reflections of sunlight among the pyramidal structures, thereby trapping the sunlight at the surface(s) of the substrate. In this way, the length of optical path of incident light in the substrate can be increased, and spectral effects of the solar cell can be enhanced, which facilitates more photons to generate electron-hole pairs at a P-N junction region on the surface(s) of the substrate. The generated electron-hole pairs are more easily separated and collected, thereby increasing the collection probability of photogenerated carriers, and improving the photovoltaic conversion efficiency of the solar cell.

Accordingly, some embodiments of the present disclosure further provide a method for manufacturing a solar cell. The method may be used to manufacture the solar cell according to the above embodiments. It should be noted that for the parts the same as or corresponding to those in the above embodiments, reference may be made to the corresponding description of the above embodiments, which will not be repeated below.

The method for manufacturing the solar cell according to the embodiments of the present disclosure includes the following operations.

At S1, a substrate is provided, where the substrate includes a first surface and a second surface opposite to each other.

At S2, at least one initial textured surface is formed by performing a first texturing process on at least one of the first surface and the second surface of the substrate, where the at least one initial textured surface includes a plurality of initial pyramidal structures.

At S3, at least one textured surface is formed by performing a second texturing process on the at least one initial textured surface, where the at least one textured surface includes a plurality of pyramidal structures, and side walls of at least some of the plurality of pyramidal structures are formed with pleated portions. One respective pleated portion of the pleated portions has a first length and includes at least one scale-like protrusion within the first length, a side wall including the respective pleated portion has a second length, and a ratio of the first length to the second length is greater than or equal to 0.5. A first texturing agent is used in the first texturing process, a second texturing agent is used in the second texturing process, and an alkali concentration in the second texturing agent is less than an alkali concentration in the first texturing agent. A temperature for the second texturing process is lower than a temperature for the first texturing process.

In the method for manufacturing the solar cell according to the embodiments of the present disclosure, at least one of the first surface and the second surface of the substrate is formed as at least one initial textured surface including a plurality of initial pyramidal structures using the first texturing process. The at least one initial textured surface can increase the roughness of at least one surface of the substrate and reduce the degree of reflection of incident light on surface of the substrate. Then, side walls of at least some of the plurality of initial pyramidal structures are formed with pleated portions using the second texturing process. One respective pleated portion of the pleated portions includes at least one scale-like protrusion. A length of the respective pleated portion is at least greater than or equal to a half of a length of a side wall of a corresponding pyramidal structure including the respective pleated portion. The pleated portions can increase roughness of side walls of the pyramidal structures, and can increase the probability of multiple reflections of sunlight among the pyramidal structures, thereby trapping the sunlight at the surface(s) of the substrate. In this way, the length of optical path of incident light in the substrate can be increased, and spectral effects of the solar cell can be enhanced, which facilitates more photons to generate electron-hole pairs at a P-N junction region on the surface(s) of the substrate. The generated electron-hole pairs are more easily separated and collected, thereby increasing the collection probability of photogenerated carriers, and improving the photovoltaic conversion efficiency of the solar cell. In the first texturing process, the formed initial pyramidal structures have relatively large dimensions. In the second texturing process, the pleated portions are formed on the side walls of the initial pyramidal structures, and have relatively fine morphologies and relatively small dimensions. Therefore, the temperature and alkali concentration required in the first texturing process are higher than those in the second texturing process. Herein, the alkali concentration refers to a mass ratio of alkali to a total mass of the texturing agent.

In some embodiments, the alkali concentration in the first texturing agent ranges from 1.8% to 2.2%, for example, 1.8%, 1.9%, 2%, 2.1%, or 2.2%. The alkali concentration in the second texturing agent ranges from 0.2% to 0.6%, for example, 0.2%, 0.3%, 0.4%, 0.5%, or 0.6%. The temperature for the first texturing process ranges from 80°C to 90°C, for example, 80°C, 82°C, 83°C, 85°C, 86°C, 88°C, or 90°C. The temperature for the second texturing process ranges from 70°C to 80°C, for example, 70°C, 72°C, 73°C, 75°C, 77°C, 79°C, or 80°C.

A duration of the first texturing process may range from 100s to 900s, for example, 100s, 150s, 200s, 230s, 300s, 340s, 400s, 460s, 500s, 520s, 600s, 670s, 700s, 740s, 800s, 850s, or 900s.

A duration of the second texturing process may range from 100s to 900s, for example, 100s, 150s, 200s, 230s, 300s, 340s, 400s, 460s, 500s, 520s, 600s, 670s, 700s, 740s, 800s, 850s, or 900s.

In some embodiments, the substrate has a first mass before performing the first texturing process, and has a second mass after performing the first texturing process, and a difference between the first mass and the second mass ranges from 0.3 g to 0.4 g, for example, 0.3 g, 0.33 g, 0.36 g, 0.39 g, or 0.4 g. The substrate has a third mass after performing the second texturing process, and a difference between the second mass and the third mass ranges from 0.03 g to 0.04 g, for example, 0.03 g, 0.033 g, 0.035 g, 0.038 g, or 0.04 g. The difference between the first mass and the second mass may serve as a monitoring means for the first texturing process, and can assist in determining the extent of forming, using the first texturing process, the initial textured surface on the substrate, thereby preventing excessive etching or insufficient etching. Similarly, the difference between the second mass and the third mass may serve as a monitoring means for the second texturing process, and can assist in determining the extent of forming, using the second texturing process, the pleated portions, thereby preventing excessive etching or insufficient etching.

The alkali used in the first texturing process may be at least one of sodium hydroxide or potassium hydroxide.

The alkali used in the second texturing process may be at least one of sodium hydroxide or potassium hydroxide.

In some embodiments, a selective etchant may also be used in the second texturing process. The selective etchant may be at least one of a polyether compound or sodium lignosulfonate. The selective etchant is conducive to selective etching of the side walls of the initial pyramidal structures in the second texturing process, thereby promoting the formation of the pleated portions.

A concentration of the selective etchant (a ratio of a mass of the selective etchant to a total mass of the etchant) may range from 0.1% to 0.2%, for example, 0.1%, 0.13%, 0.15%, 0.18%, or 0.25%.

In some embodiments, prior to performing the first texturing process, the method further includes a first cleaning process configured to remove impurities from the surfaces of the substrate. The first cleaning process uses at least alkali and hydrogen peroxide. A concentration of alkali used in the first cleaning process ranges from 0.4% to 0.6%, for example, 0.4%, 0.45%, 0.5%, 0.55%, or 0.6%. A concentration of hydrogen peroxide ranges from 3% to 5%, for example, 3%, 3.3%, 4%, 4.4%, or 5%. A temperature for the first cleaning process may range from 25°C to 50°C, for example, 25°C, 30°C, 35°C, 40°C, 45°C, or 50°C. A duration of the first cleaning process may range from 30s to 200s, for example, 30s, 50s, 80s, 100s, 140s, 180s, or 200s.

The alkali used in the first cleaning process may be at least one of sodium hydroxide or potassium hydroxide.

In some embodiments, after the second texturing process, the method further includes a second cleaning process including water washing or acid washing.

In some embodiments, upon forming the textured surface(s) on the substrate, the method further includes: disposing the substrate into a graphite boat, and forming a passivation layer on at least one surface of the substrate using plasma chemical vapor deposition. A number of contact points between the graphite boat and the substrate is greater than or equal to 5. Due to the relatively high surface roughness of the textured surface on the substrate, the number of dangling bonds at the surfaces of the substrate increases, leading to an increase in the recombination rate of carriers at the surfaces of the substrate. In the industry, with the increase of the areas of solar cells and the rise of the demand for production, a volume of a graphite boat used in plasma chemical vapor deposition gradually increases. During formation of the passivation layer using plasma chemical vapor deposition, discharge power is limited, and thus achieving both an optimal uniformity across an entire boat and an optimal thickness of the passivation layer on a single substrate becomes challenging. Typically, the substrate and the graphite boat are in contact with each other via contact points. To achieve a denser and more uniform passivation layer that matches the textured surface according to the above embodiments, the number of contact points on the graphite boat for plasma chemical vapor deposition may be increased, thereby increasing the contact area between the graphite boat and the substrate, such that the actual discharge power of a plasma exciter is increased, and thus more uniform discharge is achieved. In this way, a deposition rate and density of the passivation layer can be improved, and the hydrogen passivation effect also can be improved, thereby improving the efficiency of the solar cell by over 0.15%.

In some embodiments, one respective initial pyramidal structure of the plurality of initial pyramidal structures has a first surface area, one respective pyramidal structure of the plurality of pyramidal structures has a second surface area, and a ratio of the second surface area to the first surface area ranges from 1.3 to 1.7, for example, 1.3, 1.4, 1.5, 1.6, or 1.7. By forming the pleated portions on the sidewalls of the initial pyramidal structures, the specific surface area of each individual pyramidal structure can be further increased, thereby improving the light trapping effect of the substrate and improving the photovoltaic conversion efficiency of the solar cell.

In the method for manufacturing the solar cell according to the embodiments of the present disclosure, at least one of the first surface and the second surface of the substrate is formed as at least one initial textured surface including a plurality of initial pyramidal structures using the first texturing process. The at least one initial textured surface can increase the roughness of at least one surface of the substrate and reduce the degree of reflection of incident light on surface of the substrate. Then, side walls of at least some of the plurality of initial pyramidal structures are formed with pleated portions using the second texturing process. One respective pleated portion of the pleated portions includes at least one scale-like protrusion. A length of the respective pleated portion is at least greater than or equal to a half of a length of a side wall of a corresponding pyramidal structure including the respective pleated portion. The pleated portions can increase roughness of side walls of the pyramidal structures, and can increase the probability of multiple reflections of sunlight among the pyramidal structures, thereby trapping the sunlight at the surface(s) of the substrate. In this way, the length of optical path of incident light in the substrate can be increased, and spectral effects of the solar cell can be enhanced, which facilitates more photons to generate electron-hole pairs at a P-N junction region on the surface(s) of the substrate. The generated electron-hole pairs are more easily separated and collected, thereby increasing the collection probability of photogenerated carriers, and improving the photovoltaic conversion efficiency of the solar cell.

Those skilled in the art shall understand that the above-mentioned embodiments are specific examples for implementing the present disclosure. In practice, various changes may be made in form and details without departing from the scope of the present disclosure. Therefore, the patent scope of protection of the present disclosure shall be subject to the scope limited by the appended claims.

## Claims

1. A solar cell, comprising:
a substrate, including a first surface and a second surface opposite to each other;
wherein at least one of the first surface and the second surface is formed as a textured surface including a plurality of pyramidal structures (10), and at least some of the plurality of pyramidal structures (10) have side walls with pleated portions (11), and
wherein one respective pleated portion of the pleated portions (11) of a respective side wall of the side walls has a first length (L1) and includes one or more scale-like protrusions within the first length, the respective side wall has a second length (L2), and a ratio of the first length (L1) to the second length (L2) is greater than or equal to 0.5.

2. The solar cell according to claim 1, wherein the ratio of the first length (L1) to the second length (L2) is less than or equal to 0.8.

3. The solar cell according to claim 1 or claim 2, wherein an included angle formed between two opposite side walls of each pyramidal structure of at least some of plurality of pyramidal structures (10) ranges from 65° to 70°.

4. The solar cell according to any one of claims 1 to 3, wherein the respective pleated portion includes a plurality of scale-like protrusions connected to each other, and the plurality of scale-like protrusions have a shape of continuous irregular waves.

5. The solar cell according to claim 4, wherein an orthographic projection of scale-like protrusions of a corresponding pyramidal structure of the plurality of pyramidal structures (10) including the respective pleated portion along a direction perpendicular to the first surface or the second surface is in a form of a bud.

6. The solar cell according to any one of claims 1 to 5, wherein a recess is formed on the side wall including the respective pleated portion.

7. The solar cell according to claim 6, wherein the respective pleated portion is formed on an inner wall of the recess.

8. The solar cell according to any one of claims 1 to 7, further including a passivation layer (12) formed on the textured surface and covering surfaces of the plurality of pyramidal structures (10); and
wherein the passivation layer (12) includes first portions corresponding to the pleated portions (11), and surfaces of the first portions away from the plurality of pyramidal structures (10) have shapes same as shapes of surfaces of the pleated portions (11).

9. The solar cell according to claim 8, wherein the passivation layer (12) further includes second portions corresponding to the pleated portions (11), and surfaces of the second portions away from the plurality of pyramidal structures (10) have a smooth degree higher than the surfaces of the pleated portions (11).

10. A method for manufacturing a solar cell, comprising:
providing (S1) a substrate, wherein the substrate includes a first surface and a second surface opposite to each other;
forming (S2) at least one initial textured surface by performing a first texturing process on at least one of the first surface or the second surface of the substrate, wherein the at least one initial textured surface includes a plurality of initial pyramidal structures; and
forming (S3) at least one textured surface by performing a second texturing process on the at least one initial textured surface, wherein the at least one textured surface includes a plurality of pyramidal structures (10), and at least some of the plurality of pyramidal structures (10) have side walls with pleated portions (11);
wherein one respective pleated portion of the pleated portions (11) of a respective side wall of the side walls has a first length (L1) and includes one or more scale-like protrusions within the first length, the respective side wall has a second length (L2), and a ratio of the first length (L1) to the second length (L2) is greater than or equal to 0.5;
wherein a first texturing agent is used in the first texturing process, a second texturing agent is used in the second texturing process, and an alkali concentration in the second texturing agent is less than an alkali concentration in the first texturing agent; and
wherein a temperature for the second texturing process is lower than a temperature for the first texturing process.

11. The method according to claim 10, wherein the alkali concentration in the first texturing agent ranges from 1.8% to 2.2%, and the alkali concentration in the second texturing agent ranges from 0.2% to 0.6%; and
wherein the temperature for the first texturing process ranges from 80°C to 90°C, and the temperature for the second texturing process ranges from 70°C to 80°C.

12. The method according to claim 10 or claim 11, further comprising:
disposing the substrate into a graphite boat; and
forming a passivation layer (12) on at least one surface of the substrate using plasma chemical vapor deposition;
wherein a number of contact points between the graphite boat and the substrate is greater than or equal to 5.

13. The method according to any one of claims 10 to 12, wherein one respective initial pyramidal structure of the plurality of initial pyramidal structures has a first surface area, one respective pyramidal structure of the plurality of pyramidal structures (10) has a second surface area, and a ratio of the second surface area to the first surface area ranges from 1.3 to 1.7.

14. The method according to any one of claims 10 to 13, wherein the substrate has a first mass before performing the first texturing process, and has a second mass after performing the first texturing process, and a difference between the first mass and the second mass ranges from 0.3 g to 0.4 g; and
wherein the substrate has a third mass after performing the second texturing process, and a difference between the second mass and the third mass ranges from 0.03 g to 0.04 g.

15. The method according to any one of claims 10 to 14, wherein a selective etchant is used in the second texturing process.
